Europäisches Patentamt

European Patent Office

Office européen des brevets

(19)

(11) **EP 0 741 336 A1**

## (12) EUROPEAN PATENT APPLICATION

(43) Date of publication:
06.11.1996 Bulletin 1996/45

(51) Int. Cl.$^6$: **G03F 9/00**

(21) Application number: 95106746.1

(22) Date of filing: 04.05.1995

(84) Designated Contracting States:
AT BE CH DE DK ES FR GB GR IE IT LI LU MC NL PT SE

(71) Applicant: **MINNESOTA MINING AND MANUFACTURING COMPANY**
**St. Paul, Minnesota 55144 (US)**

(72) Inventors:
 • **Gysae, Friedrich-Wilhelm**
 **D-41541 Dormagen (DE)**

 • **Parschau, Roland**
 **D-78532 Tuttlingen (DE)**

(74) Representative: **Bird, William Edward et al**
**Office of Intellectual Property Counsel,**
**3M Europe S.A./N.V.**
**Hermeslaan 7**
**1831 Diegem (BE)**

Remarks:
Amended claims in accordance with Rule 86 (2) EPC.

(54) **Method of producing flexible offset printing plates and an apparatus therefor**

(57) A method is described for processing an unfinished flexible offset printing plate (10) having at least one image and registration indicia, whereby each at least one image is in a predetermined position with respect to corresponding registration indicia, comprising the steps of:

1) positioning said unfinished offset printing plate (10) on the surface of a base member (20) using the registration indicia as a reference;
2) holding a substantial part of the surface of the unfinished printing plate (10) in close contact with the surface of the base member (20);

3) punching printing press reference locations into the unfinished offset printing plate using the registration indicia as references; and

4) cutting the unfinished offset printing plate to length using the registration indicia as references without removing the printing plate from the apparatus.

An apparatus is described for carrying out the method and includes a base member (20), a registering device (26), a vacuum clamping unit (27), a punching unit (30) and a cutting unit (40).

FIG 3        SECTION III-III

## Description

The present invention is related to a method of producing flexible offset printing plates and an apparatus therefor. The printing plate made in accordance with the invention is of the kind having image setter registration indicia such as deformations or holes and printing press reference locations such as notches or holes. The printing plate made in accordance with the present invention is particularly suitable for application to a printing plate cylinder of an offset printing press having a locking device for the printing plate.

A conventional method of producing an offset printing plate comprises applying a photosensitive layer to a thin dimensionally stable aluminium sheet having an accurately defined contour as well as stamped registration holes and printing press reference notches in an exact predetermined pattern relative to the edges of the sheet. Reprographic film having the same registration hole pattern as the aluminium sheet is exposed with a desired image, developed and fixed. The exposed film is superimposed on the photosensitive layer of the aluminium sheet using the reference holes in the sheet and the exposed film to obtain an exact registration. The composite is then exposed to form a contact print of the image on the photosensitive layer which is then developed and fixed. Typically the edge opposite the reference hole pattern is bent or crimped to an acute angle. The finished printing plate is transferred to the printing plate cylinder and secured as is disclosed, for instance, in US-A-4 702 166 using the notches as a positional reference.

By this procedure a good registration of the image to the edges of the printing plate is obtained as well as registration of the image to the registration indicia and to the printing press reference notches. For monochromic printing, a registration tolerance of $\pm$ 0.5mm may be accepted. However, for colour printing, a printing plate must be made for each colour and the different colour plates are printed in sequence. Hence, a much higher registration tolerance is required to guarantee that the superimposed printed colour images produce an acceptable final picture. The registration in this case must be better than $\pm$ 30$\mu$m. The quality of printing depends, to a large extent, on the care with which pre-printing preparations are carried out.

More recently polymer base printing plates have been used as disclosed in US-5 052 120. The material for these plates is provided in continuous photographic plate form and the plate material can be exposed directly in an image setter. In the image setter, the registration indicia are introduced so that the image has a defined position with respect to the registration indicia. The guidance of the flexible plate material through the image setter is not perfect so that there may be no exact defined relationship between the image and the edges of the flexible plate material. If the rolled plate material is cut into individual plates in the image setter, the cutting tolerance is usually poor. The plate product produced causes considerable problems at the printing press. In US-A-5 052 120 adjustable clamping devices for the print roller have been proposed which may accommodate the poor dimensional accuracy of the plates.

Recently automatic plate loading devices have been introduced for automatically loading printing plates into the printing press as described in EP-A-0 329 870. Such automatic loading devices require accurately dimensioned printing plates. However, with such devices there is little capability of automatic in process adjustment of the clamping devices on the printing roll to accommodate dimensional variations in the printing plate.

An apparatus is known from US-A-5 255 607 for projecting an image onto a printing plate, developing and fixing the image and punching printing press references notches into the plate. The starting material is an accurately dimensioned aluminium printing plate. The device is complicated and can not be used with the continuous imaged product from a conventional image setter.

## SUMMARY OF THE INVENTION

The present invention provides a method for processing an unfinished flexible offset printing plate having at least one image therein and at least one registration indicia, whereby each at least one image is in a predetermined position with respect to said at least one registration indicia, comprising the steps of:

positioning said unfinished offset printing plate using the at least one registration indicia as a reference;
holding a substantial part of the unfinished offset printing plate in a predetermined position;
cutting printing press reference locations into the unfinished offset printing plate using the at least one registration indicia as a reference; and
trimming the unfinished offset printing plate to length using the at least one registration indicia as a reference without removing the unfinished offset printing plate from the apparatus, so that the image, the cut edge or edges and the printing press reference locations of the printing plate are in predetermined spatial relationships to each other and to the at least one registration indicia.

The present invention also provides an apparatus for processing an unfinished flexible offset printing plate, said unfinished offset printing plate having at least one image therein and at least one registration indicia, each at least one image having a predetermined spatial relationship to the at least one registration indicia, comprising:

a registration device for determining the position of the unfinished offset printing plate using the at least one registration indicia as a reference;

means for holding a substantial part of the unfinished printing plate in a predetermined position with respect to said registration device;

at least one reference location cutting device for cutting printing press reference locations in the unfinished offset printing plate in a predetermined spatial relationship to the at least one registration indicia; and

a trimming unit for cutting the unfinished offset printing plate to a predetermined length with reference to the at least one registration indicia.

The present invention also provides a set of at least three polyester or paper backed printing plates, each printing plate representing a different colour content of a single image, each printing plate having at least one bent edge or crimp and printing press reference locations or press alignment holes and each printing plate being mountable on the printing press so that each printing plate image will be in alignment with each of said at least three printing plates within a tolerance of less than ±30 micrometers.

The present invention may provide the advantage that finished printing plates, in particular polymer based printing plates, are dimensioned accurately.

The present invention may also provide the advantage that existing capital intensive equipment, e.g. image setters and printing presses, can be utilised without modification.

The present invention may provide the additional advantage that the printing plates produced may be used with existing printing presses and automatic printing press loading devices.

The present invention may provide the additional advantage that continuous plate material from conventional image setters can be accurately finished.

The present invention may provide the advantage of a low cost process and a low cost and compact apparatus for preparing printing plates.

The present invention may have the advantage of providing a method of preparing printing plates and an apparatus therefor with which the amount of time and handling is reduced.

The dependent claims define further embodiments of the present invention.

The present invention, its advantages and embodiments are described in the following with reference to the drawings.

BRIEF DESCRIPTION OF THE DRAWINGS

Fig. 1 shows an unfinished printing plate;
Fig. 2 shows a printing plate prepared in accordance with the present invention;

Fig. 3 shows a section through an apparatus in accordance with the first embodiment of the present invention;

Fig. 4 shows a section through a further apparatus in accordance with the first embodiment of the present invention;

Fig. 5 shows a front and a side view of an apparatus in accordance with the first embodiment of the present invention;

Fig. 6 shows a cutting unit according to the first embodiment of the present invention;

Fig. 7 shows a further cutting unit according to the first embodiment of the present invention;

Fig. 8 shows a schematic diagram for explaining an apparatus in accordance with a second embodiment of the present invention;

Fig. 9 shows a front and a side view of an apparatus in accordance with the second embodiment of the present invention;

Fig. 10 shows a bending unit according to the second embodiment of the present invention;

Figs. 11A and B show further bending units in accordance with the second embodiment of the present invention;

Fig. 12 shows still a further bending unit in accordance with the second embodiment of the present invention;

Fig. 13 shows results of bending trials with an apparatus according to the second embodiment of the present invention; and

Fig. 14 shows a combined bending and cutting unit for use with the second embodiment of the present invention.

DESCRIPTION OF THE PREFERRED EMBODIMENTS OF THE INVENTION

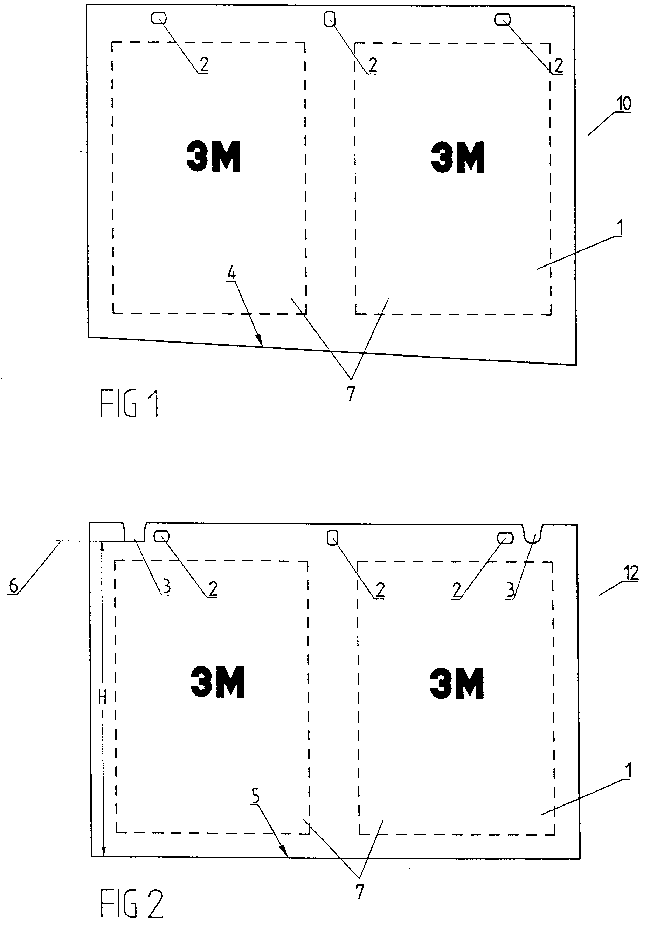

The present invention will be described with respect to the printing plate 10,12 shown in Figs. 1 and 2. The present invention is not limited to this type of printing plate but may be applied to any printing plate having image setter registration indicia 2 and printing press reference locations 3 which are used for securing the printing plate in the printing press and for providing the correct registration between the printing press and the printing plate. In the following the present invention will be described with reference to printing plates 10,12 in which the registration indicia 2 are holes having a round, oval or any other suitable shape. The invention is not limited thereto. The registration indicia may be deformations of plate 10,12, markers or raised portions attached to the surface of the plate 10,12 or particular references images in the plate 10,12, e.g., black or clear circles, crosses, chequered areas or similar. Each different type of registration indicia is designed to work with a particular device which positions the plate in the correct registration. For instance, where images in the plate 10 are used the images may be identified by video cameras and the plate 10 moved to the correct position manually or automatically. For holes 2 the appropriate registration device is pins protruding from the surface of where the plate is to be mounted. In the following reference will be made to pins however the invention is not limited thereto. For other registration systems the pins should be exchanged for the appropriate registration device.

The printing plate to be processed in accordance with the invention can be based on any suitable dimensionally stable material such as paper; plastics such as polyester, vinyl, polyethylene, polyurethane or similar; metals such as copper, aluminium, stainless steel, steel or iron alloys or similar; rubbers such as silicone rubber; carbon fibre reinforced polymers or mixtures or combinations of these materials. The printing plate may be as large as the biggest posters produced by offset printing and may have dimensions exceeding 1.5 x 2.0 m. The printing plates of the present invention are preferably silver halide diffusion transfer printing plates on polymeric film (e.g., polyester) or paper substrates.

As shown in Fig. 1 an unfinished printing plate 10 received in the cut state from the image setter/developer has an image 7 which is in a defined spatial relationship to the image setter registration indicia 2. The invention is not limited thereto. The invention may also be applied to printing plates not having an image 7. Due to the poor cutting tolerances in the image setter/developer, the edge 4 is normally not in a defined relationship to the image 7 which is shown in the figure as an exaggerated slope to this edge 4.

Plate 10 may also be in the form of a roll (not shown) with a plurality of images 7, each of which has corresponding image setter registration indicia 2.

The apparatus and the method in accordance with the present invention may produce the plate 12 as shown in Fig. 2 either from pre-cut plates 10 or from a roll of plates 10. In addition to the registration indicia 2, the plate 12 has printing press locations 3 for setting up in the printing press and the edge 5 has been cut accurately to a predetermined length "H" from the printing press reference notches 3 (i.e., from line 6 through the bottom of notches 3 for instance) whereby "H" is derived from the diameter of the printing plate cylinder of the printing press while making allowance for the clamping device of the printing plate cylinder of the press. Printing plate 12 in accordance with Fig. 2 has an accurate predetermined relationship between the positions of the image 7, the printing press reference notches 3 and the edge 5 so that the plate is suitable for automatic loading into the printing press and also for colour printing.

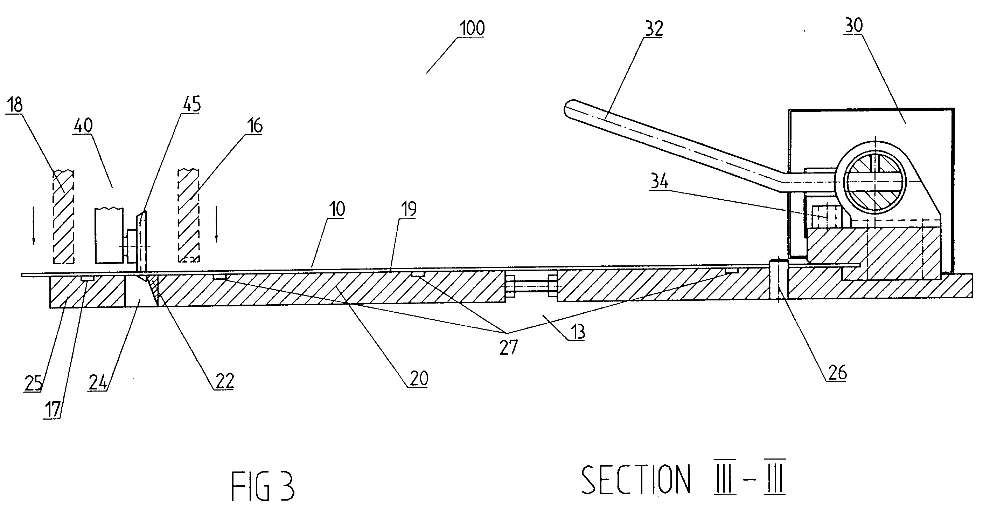

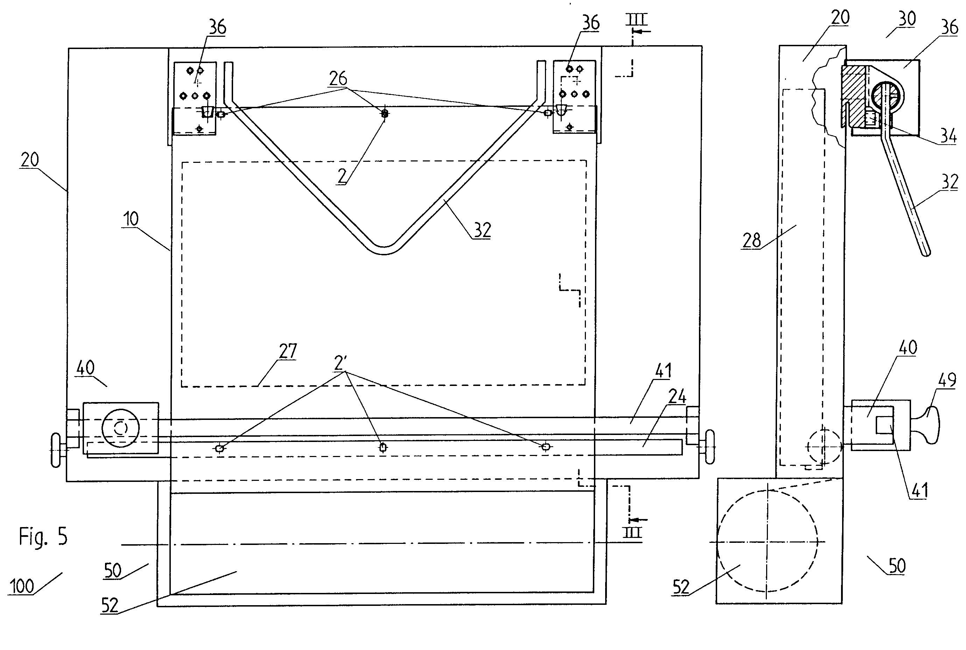

Fig. 3 shows a cross-section (see Fig. 5) through an apparatus 100 in accordance with the first embodiment of the present invention. The apparatus 100 may either be used with individual rough-cut plates 10 or with a roll 52 of plate material held in a container 50 (not shown in Fig. 3). With unfinished rough-cut plates 10, one of the plates 10 is positioned on the surface 19 of a base member 20 by means of register pins 26 which conform exactly to the image setter registration indicia 2. The pins 26 may be made retractable to ease mounting. With a roll 52, the leading edge of the material is drawn up to and then positioned on pins 26 using registration indicia 2.

Most printing plate materials have a degree of curl after imaging and developing. On the printing press plate cylinder, a printing plate 12 is in close contact with the surface of the roller. This is normally achieved by tensioning the plate 12. In order to cut the plate 10 to the length which corresponds to the required length on the plate cylinder, it is necessary that any curl is taken out of the plate 10 before cutting. According to the first embodiment of the invention this may be achieved if a substantial part of the surface of the plate 10 is in close contact with the surface 19 of the base member 20. The base member 20 may be a base plate 20. Further, it is preferable if plate 10 remains firmly in place on the base member 20 while the punching and cutting operations take place so that there is no change of registration.

According to this embodiment of the invention, plate 10 may be smoothed down to the surface 19 of the base member 20 by hand and then held in place by a holding member 16 extending across the width of plate 10 and located adjacent the cutting edge 22 as shown in Fig. 3. A device (not shown) may be mounted over the plate 10 producing air jets directed towards the plate 10 to smooth plate 10 onto surface 19 of the base member 20 before plate 10 is finally held in place by bringing holding member 16 into its clamping position. Alternatively, the air jet device and holding member 16 may be replaced by a holding plate (not shown) which is clamped over a substantial area of the plate 10. It is preferred however, if the means for bringing the plate 10 into close, pressed contact with the base member 20 is provided by a vacuum clamp. The vacuum clamp may be provided in the surface 19 of the base member 20, comprising a plurality of vacuum channels 27 or holes (not shown), for instance as disclosed in DE-A-4335735, which are connected to a vacuum pump. The channels 27 or holes should be narrow enough that plate 10 is not deformed substantially when vacuum is applied but wide enough to clamp plate 10 during the subsequent finishing operations. It is preferable if the vacuum clamp covers an area extensive enough to clamp a substantial area of the surface of the plate 10 to base plate 20. For additional security a vacuum clamp and a holding member 16 may be provided. If plate 10 is made of magnetic material the vacuum clamp may be replaced with a magnetic clamp, the movable magnetic poles being provided in base member 20.

At a predetermined distance from the register pins 26 a channel or groove 24 may be provided in the base member 20 for accommodating a slitting or cutting knife 45 which cuts against an accurately defined straight edge 22. The cutting edge 22 is preferably made of hardened steel or similar. The section 25 of the base member 20 on the side of channel 24 remote from the register pins 26 may be provided with its own vacuum channel 17 which is controlled separately from the channels 27. With rolled material 52 the vacuum may be maintained in channel 17 to hold the leading edge of the next plate 10 after cutting of the first plate 10. Alternatively a further holding member 18 may be used to secure the leading edge of the next plate 10 to the end section of base member 20. Optionally, channel 24 may be dispensed with and base member 20 terminated with the cutting edge 22. To provide a fine adjustment of the final cut length of the plate 10, an adjustment means 13 may be provided in base plate 20 as shown schematically in Fig. 3. To provide a fine adjustment of the final length of the plate 10, an adjustment means 13 may be provide in base plate 20 as shown schematically in Fig. 3.

A printing press reference location cutting unit 30 may be provided adjacent the register pins 26 for cutting the printing press notches 3 into the plate 10. The reference location cutting unit may be a punch having the shaped dies 34. The punching unit 30 may be hand operated by means of the handle 32 or may be motor driven, activated by air or hydraulic pressure or by any other suitable means. Alternatively the reference location cutting unit 30 may be any suitable cutting unit, e.g., a laser cutter.

The invention is not limited to a flat base member 20. The base member 20 may be a cylinder of the appropriate diameter (not shown) having protruding register pins 26 and a channel 24 with cutting edge 22 inset in its surface at the appropriate distance around the circumference from the register pins 26. Vacuum channels in the surface of the cylindrical base member may hold the plate 10 onto the surface thereof and maintain the position of the plate 10. A slitting or cutting knife 45 may be mounted to cut the plate 10 against the cutting edge 22. A punching unit 30 may be mounted on the cylinder in a predetermined relationship to the register pins 26.

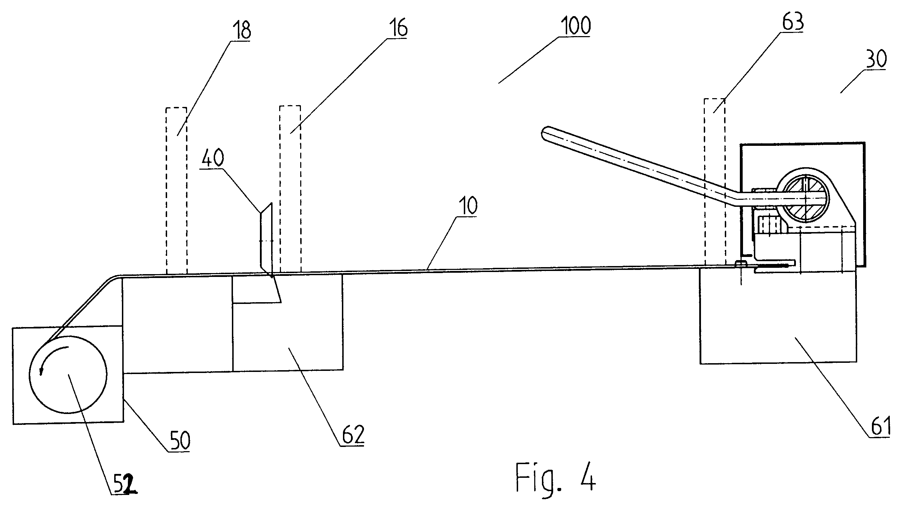

Further, the base member of the present invention is not limited to a solid base plate 20. Base member 60 in accordance with the present invention may be provided by a first base member part 61 and a second base member part 62 as shown in Fig. 4. Punch units 30 and register pins 26 may be mounted on first part 61. Both the first and second base member parts 61,62 may extend at least across the width of the printing plate 10. The first base member part 61 may be, however, a series of individual stations, on each of which a register pin 26 or a punch unit 30 is mounted. A container 50 may be attached to second part 62. A roll 52 of plate material may be mounted on a back-tensioned core in container 50. The leading edge of roll 52 is pulled against the back-tension and located on register pins 26. A holding member 63 may be provided to clamp plate 10 to the first part 61. A further holding member 18 may be provided to clamp the leading edge of the next plate 10 to the second part 62 in order to avoid the new leading edge being pulled back into the container 50 by the roll back-tensioning device alter cutting. Holding member 16 may be provided adjacent to cutting edge 22 to hold plate 10 during cutting. Plate 10 is then cut using the trimming or cutting unit 40 mounted on the second part 62. As plate 10 is installed between the first and second parts 61,62 under tension, plate 10 is cut accurately to length.

In the apparatus 100 in accordance with the present invention, the register pins 26 provide a means for positioning the plate 10. Either by tensioning the plate 10 between base member parts 61,62 or by holding the plate 10 in close contact with the base plate 20, plate 10 is held so that a substantial part of the surface of the plate 10 is in a defined position with respect to the positioning means 26. This guarantees that the plate 10 is cut accurately.

Fig. 5 shows front and side views of apparatus 100 according to the first embodiment of the present invention. Components having the same reference numbers in Fig. 5 and Figs. 3 and 4 are the same. The apparatus 100 in accordance with Fig. 5 has been designed to work with a roll 52 of printing plates 10, which is placed in a container 50. The container 50 is attached to the base plate 20 at the opposite end thereof from the punching units 36. Apparatus 100 may, however, be used with discrete plates 10. A vacuum chamber 28 is provided in the base plate 20 and is connected to the vacuum channels 17,27 and to a vacuum pump (not shown). The chamber 28 may be a segregated chamber as described in DE-A-4335735. The base member 20 as shown is rectangular, but the invention is not limited thereto. Two punching units 36 are mounted at one edge of the base plate 20. Register pins 26 are located on the base member 20 in a predetermined relationship to the punch dies 34.

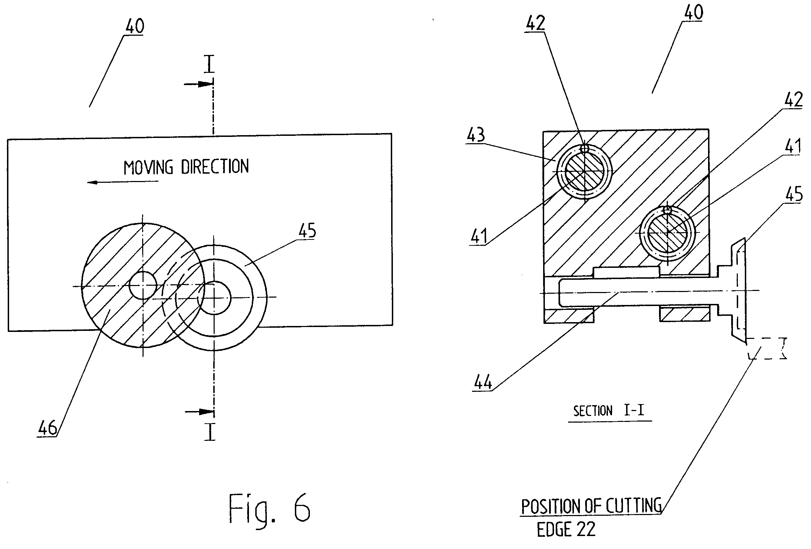

Spaced from the punching units by the appropriate distance is a channel or groove 24 in the base for accommodating the end of the slitting knife 45 of a finishing unit 40 which in this embodiment is a cutting unit. The trimming or cutting unit 40 runs on a guide rail 41 which is fixed at the appropriate elevation above the surface of the base plate 20. The guide rail 41 may be square as shown in Fig. 5, round as shown in Fig. 6 or any other suitable shape. As shown in Fig. 6, the cutting knife 45 may be, for example, a rotating knife attached to a shaft 44 which is journalled in a housing 43. It is preferable if the rotating knife is self-sharpening. The housing 43 may be located movably on guide rails 41 by means of bearings 42. Further, the cutting unit 40 may be provided with one or more pressing rollers 46 as shown in Fig. 6 for trapping the plate 10 to the surface of the base member 20, and in particular adjacent the cutting edge 22, just in front of the cutting knife 45. The roller 46 is preferably made of hard rubber or have a rubber cover, wrap or tyre.

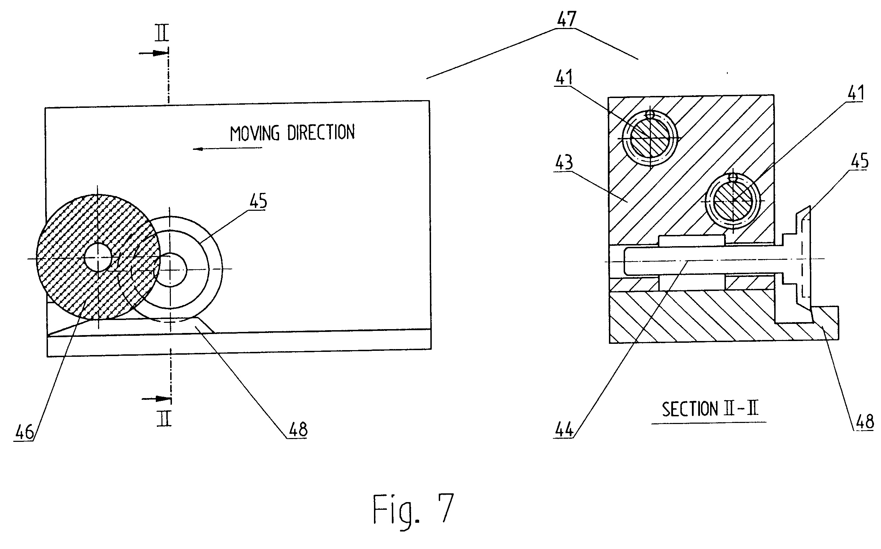

Fig. 7 shows a further trimming or cutting unit 47 in accordance with the first embodiment of the invention. Instead of the cutting edge 22 being provided on the base member 20, the cutting unit 47 has a cutting edge 48 which is attached to the cutting unit 47 to support the plate 10 at the cutting position. Cutting edge 48 co-operates with the cutting knife 45 to cut plate 10. The surface of the cutting edge 48 in contact with the underside of plate 10 may lie substantially in the same plane as the surface 19 of the base plate 20. The cutting knife 45 may be preferably a rotating cutting knife and is preferably self-sharpening. With cutting unit 47, the cutting edge 22 is not provided on the base member 20 in the channel 24. It is advantageous if the surface of the cutting edge 48 in contact with the under surface of the plate 10 is provide with a low friction surface such as Teflon®. Channel 24 may be made wider to accommodate the cutting edge 48 as well as the cutting knife 45. Optionally, channel 24 may be dispensed with entirely and base plate 20 simply terminated. It is advantageous to provide at least one pressing roller 46 on the cutting unit 47, which bears on the plate 10 and presses plate 10 to the upper surface of the cutting edge 48. Viewed in the direction of motion of the cutting knife 45, the pressing roller 46 lies just in front of the cutting knife 45.

Trimming or cutting units 40 and 47 with rotating cutting knives 45 have been described. The invention is not limited thereto. The cutting system of cutting units 40 and 47 may be any suitable system, e.g., inclined razor blade, hot wire or laser cutters.

A printing plate 10 is processed as follows. The leading edge of the roll 52 is brought up and located on the register pins 26. The vacuum generated in vacuum chamber 28 is applied to vacuum channels 17,27 to clamp and maintain the position of the first plate 10 of the roll 52 with respect to the base member 20. The register holes 2' of the next printing plate 10 lie beyond the cutting line of the cutting device 40. When provided, holding members 16,18,63 are applied. The punching unit 30 is then operated to punch the printing press reference notches 3 into plate 10. Plate 10 is cut to a predetermined accurate length by means of the trimming or cutting unit 40. As shown in Fig. 5 the cutting unit 40 has a knob 49 and is moved across the width of the plate 10 by hand. The invention is not limited to hand operation. The cutting unit 40 may be driven by any kind of suitable motor, air or hydraulic pressure. According to the first embodiment of the present invention, plate 10 may first be cut and then punched or vice versa.

To release the finished plate 12 from rolled material, the vacuum is released from channels 27, holding members 16,63 released, if present, and finished plate 12 is removed. Vacuum is then released from channel 17, the leading edge of the roll grasped firmly, holding member 18 is released if present, the new leading edge is brought up to the register pins 26 and the cycle described above is repeated. Where pre-cut unfinished plates 10 are used, the vacuum is released from channels 27, holding members 16,63 released, if present, and finished plate 12 is removed. The cycle is repeated with a new plate 10.

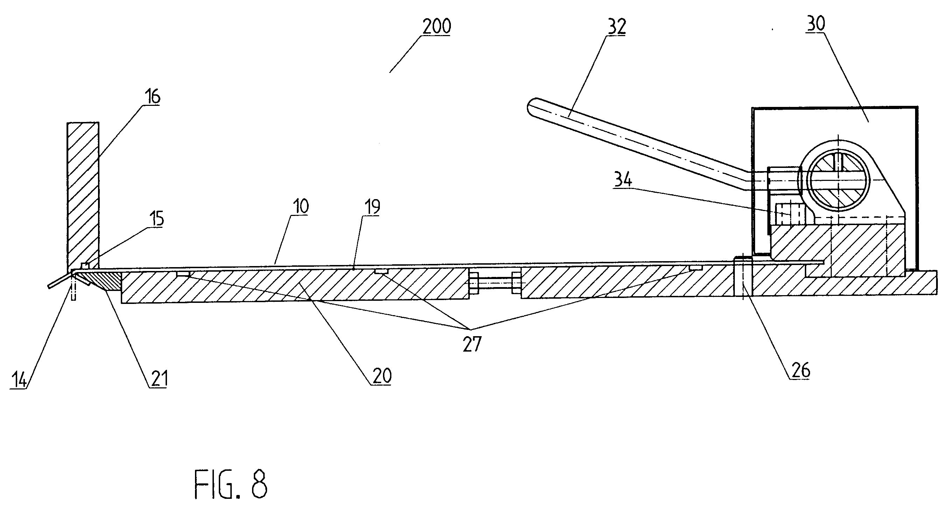

Fig. 8 shows a cross-section through an apparatus 200 in accordance with a second embodiment of the present invention. Components with the same reference numbers in Fig. 8 and Figs. 3 to 7 are the same. The second embodiment of the invention will be described with reference to a base plate 20. The invention is not limited thereto. Base member 60 as described with respect to Fig. 4 may also be used with the second embodiment. In accordance with the second embodiment, the plate 10 is first cut and then an end portion 14 of the plate 10 having a predetermined length is bent to a predetermined angle about a hardened bending edge 21. In order to obtain accurate bending, a pressing member 16 may pressed against the plate 10 at the bending edge 21 during the bending operation. The pressing member 16 may have a small protrusion on the edge overlapping the bending edge 21 in order to angle the end of plate 10 downwards as shown in Fig. 8. Further, pressing member 16 may have a vacuum channel 15 in the end surface facing the plate 10. After the bending operation the vacuum may be maintained in channel 15 while pressing member 16 is lifted. The end of plate 10 is thus released from base plate 20.

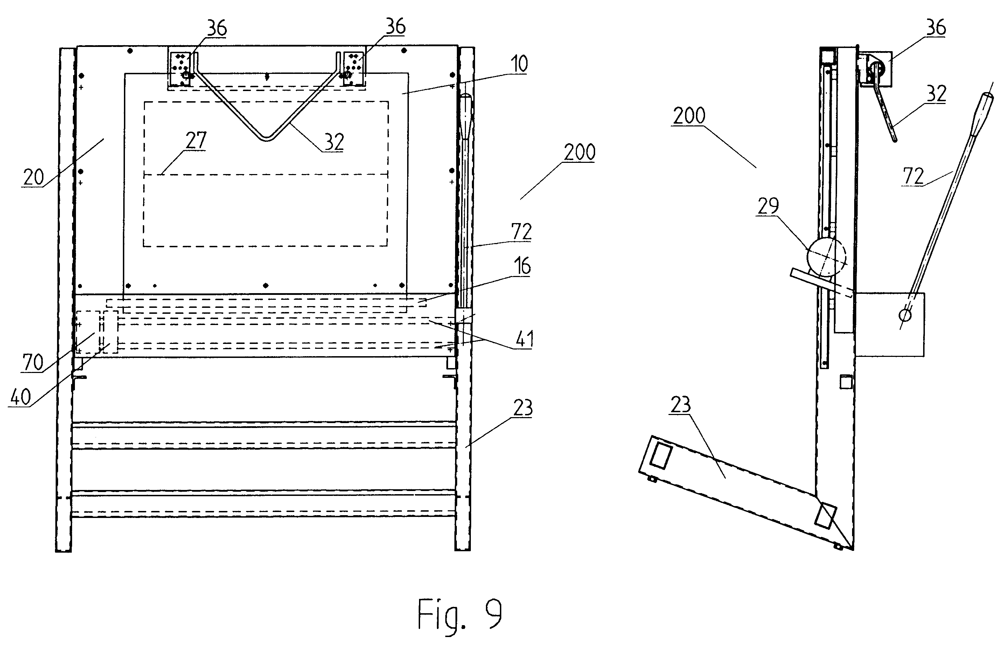

Fig. 9 shows a front and a side view of an apparatus 200 in accordance with the second embodiment of the present invention without a plate 10 in place. Components with the same reference numbers in Fig. 9 and Figs. 3 to 8 are the same. In accordance with the second embodiment the apparatus 200 carries its own vacuum pump 29, a modification which may also be applied to all other embodiments of the invention. Vacuum channels 27 may be provided in the surface of base member 20. The trimming and bending units 40,70 are both provided on common guide rails 41. The trimming unit 40 is separate from the bending unit 70. A handle 72 is provided for bringing the pressing member 16 into pressing contact with the plate 10 by means of an eccentric cam.

The base plate 20 is attached to an angled foot 23. When placed on a table the base plate 20 slopes backwards away from the operator at an angle of 70° to the vertical. The foot 23 may also be used with the other embodiments of the invention. The punching units 36 and the register pins are located at the upper edge of base plate 20. The near vertical base member 20 has the advantage that the weight of plate 10 tends to pull the plate 10 straight. Further, the unit is at an ergonomically advantageous angle and reduces space requirements.

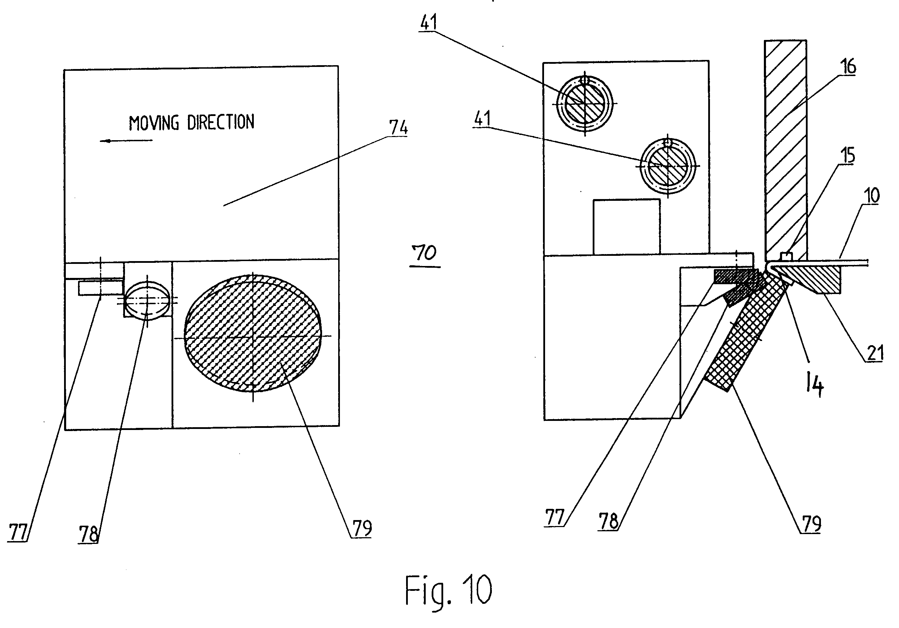

A bending unit 70 is shown in more detail in Fig. 10. The bending unit 70 includes a bending head 74 which travels along guide rails 41. Two or more pre-bending rollers 77,78 are rotatably mounted on the bending head, each pre-bending roller 77,78 applying pressure at a different angle to the end portion 14 of the plate 10. The final bending operation is carried out by a larger final bending roller 79 which lies slightly behind the pre-bending rollers 77,78 as looked at with reference to the movement direction of the bending head 74. Bending roller 79 presses plate 10 firmly against the sloping underside surface of the bending edge 21. The bending head 74 may be moved by hand or driven by any suitable motor, by hydraulic or pneumatic means or by any other suitable system.

As the cutting edge 22 of Fig. 3 could impede bending, a trimming or cutting unit 40 having a cutting head 47 and including cutting edge 48 as shown in Fig. 7 is preferred for apparatus 200 of the second embodiment having a bending head 74. A channel 24 is not required as it would also impede bending. The bending edge 21 terminates the base plate 20 as shown in Fig. 8.

In accordance with the second embodiment, the pre-cut plate 10 or the leading edge of the roll 52 is located on the register pins 26 and secured to the base member 20 by application of vacuum. Handle 72 is moved to clamp pressing member 16 in place thus holding the plate 10 adjacent to the bending edge 21. Then cutting unit 47 is moved across the width of the plate 10 to cut the plate 10 to the required length. Subsequently bending head 74 is moved across the width of the plate 10 to bend end portion 14 of the plate 10. Handle 72 is now released. Pressing member 16 is lifted with vacuum maintained in channel 15, thus freeing the bent end portion 14 of plate 10 from the bending edge 21. Plate 10 is then removed as previously.

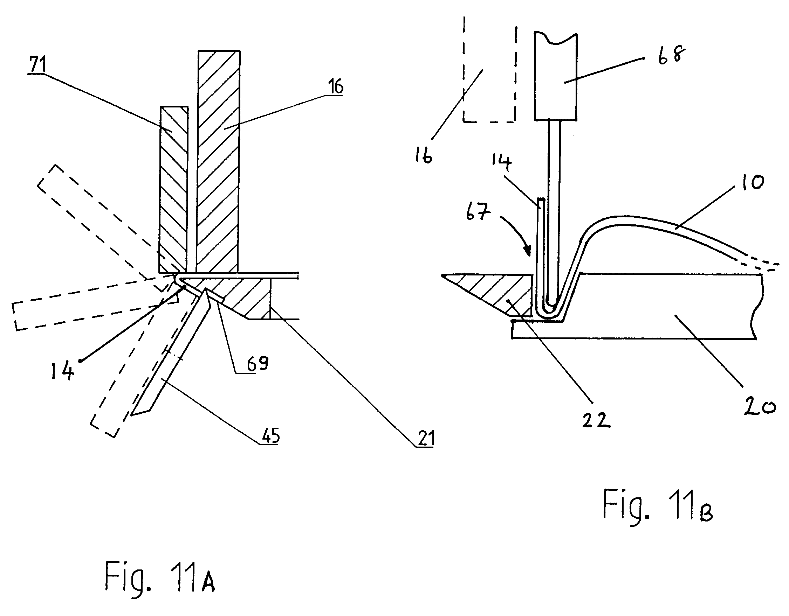

The invention is not limited to bending rollers nor is the invention limited to any specific sequence of punching, cutting and bending. With reference to Fig. 11A, the end portion of base plate 20 is shown in detail for a modification of the second embodiment. Bending is carried out by a bending member 71 which extends across the width of the plate 10 and is arranged to rotate from a position as shown to a position in which it presses end portion 14 of plate 10 against the under side of bending edge 21. While holding the end portion 14 securely against bending edge 21, a cutting means 45, which may be a rotating knife co-operating with the edge of depression 69, cuts the plate 10 to length. The cutting means 45 may be any suitable cutting means such as a laser cutter.

If the included angle of the bent end portion 14 is to be about 45°, the bending edge 21 becomes relatively thin and weak. A modification to the second embodiment is shown in Fig. 11B for producing an end portion 14 with a small included angle. The method is based on that described in US-A-4 643 093 which is incorporated by reference. A cutting edge 22 is provided which is movable with respect to the base plate 20. A groove 67 is provided between the base plate 20 and cutting edge 22 across the width of plate 10. After cutting, pressing member 16 is raised and vacuum may be released before an elongated blade 68 is lowered to force plate 10 into groove 67. Immediately after blade 68 is raised, cutting edge 22 and base plate 20 are forced together by hydraulic rams or other suitable devices and the plate 10 is trapped in groove 67 and crimped. The walls of groove 67 are preferably made sloping so that the crimp occurs mainly at the bend of plate 10 in the groove 67. Cutting edge 22 and/or plate 20 may be heated if required.

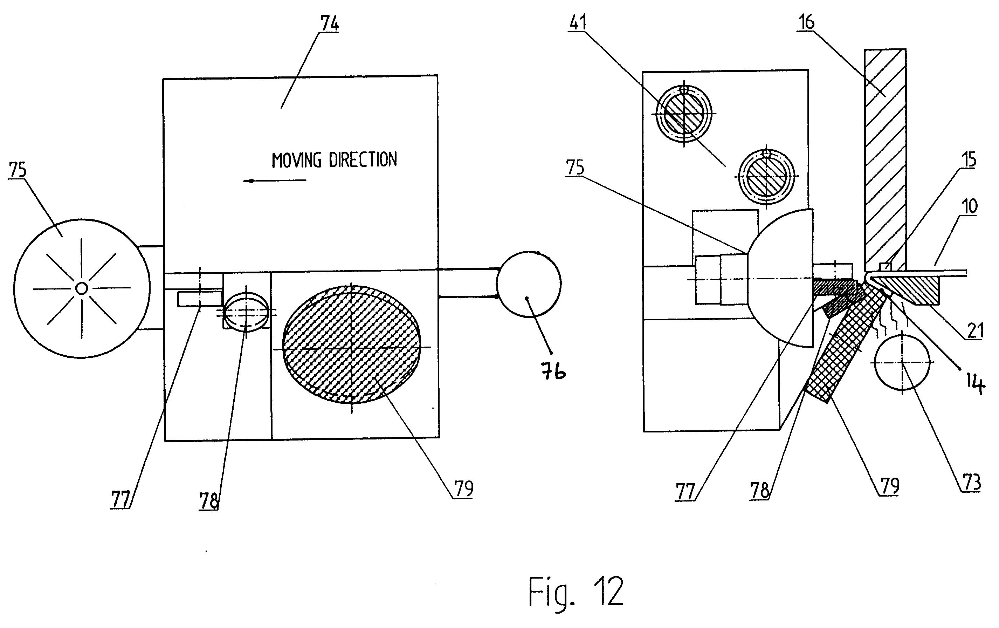

A modification of the bending head 74 of the second embodiment is shown schematically in Fig. 12. With polymer based printing plates there is a tendency for end portion 14 to spring back after bending. Depending on the material of plate 10, increased accuracy of the bending operation may be achieved by heating the end portion 14 of plate 10. Heating means 73,75 may be provided. The heating means may be an infra-red or ultra-violet lamp 75 directed towards the bend of plate 10 and mounted on the bending head 74. The choice of heating means 75 may be dependent upon the spectral sensitivity of the plate and the opacity of the substrate to assure that there is no exposure of the plate. The infra-red or ultra-violet light may be focused by means of a parabolic reflector onto the bend of plate 10. Alternatively the heating means 75 may be a hot air gun blowing hot air towards the bend of plate 10. Optionally, means 76 may be provided for applying cooling air or water jets. Additionally or alternatively the heating means may be an extended radiant and/or convection heater 73 which may extend across the width of the plate 20 and be attached to the base member 20 in such a position that it can heat the end portion 14 of plate 10 as well as the bending edge 21. As an alternative, the bending edge 21 may be heated directly by passing electric current therethrough.

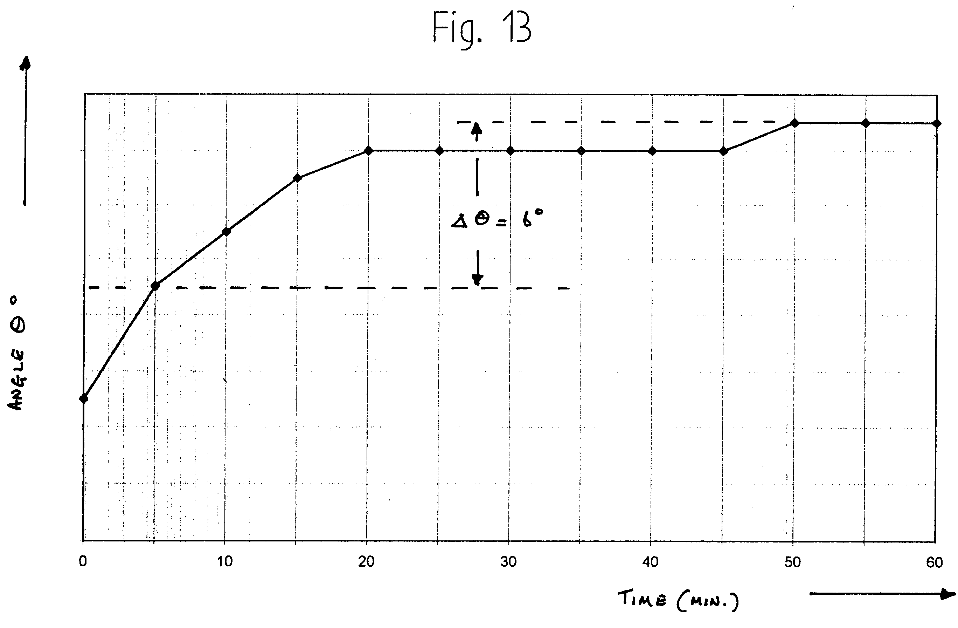

The action of the bending unit 70 is to change the elastic memory of the material of the printing plate 10, either by exceeding elastic deformation limits of the plate material by heat and/or pressure or by excessive bending to the point of fracturing or re-ordering internal polymer alignments. Fig. 13 shows results of bending trials carried out with apparatus in accordance with the second embodiment of the invention at room temperature using a polyester based HeNe ONYX® diffusion transfer printing plate made by Minnesota Mining and Manufacturing Co. St. Paul, USA. The plate was 0.18 mm thick and 762 mm wide. Alter bending most materials exhibit a degree of spring-back. Accordingly, the included angle of the bending edge 21 is normally made smaller than the finally required angle. The angle of the bending edge 21 was chosen for the trials so that the included angle $\vartheta$ of the end portion 14 of plate 10 was about 85° immediately alter bending. As can be seen from Fig. 13, the included angle of end portion 14 lay within a tolerance angle of $\Delta\vartheta = 6°$ in a time of 5 minutes to over 1 hour after bending. This is sufficient time to mount the finished plate 12 in the printing press.

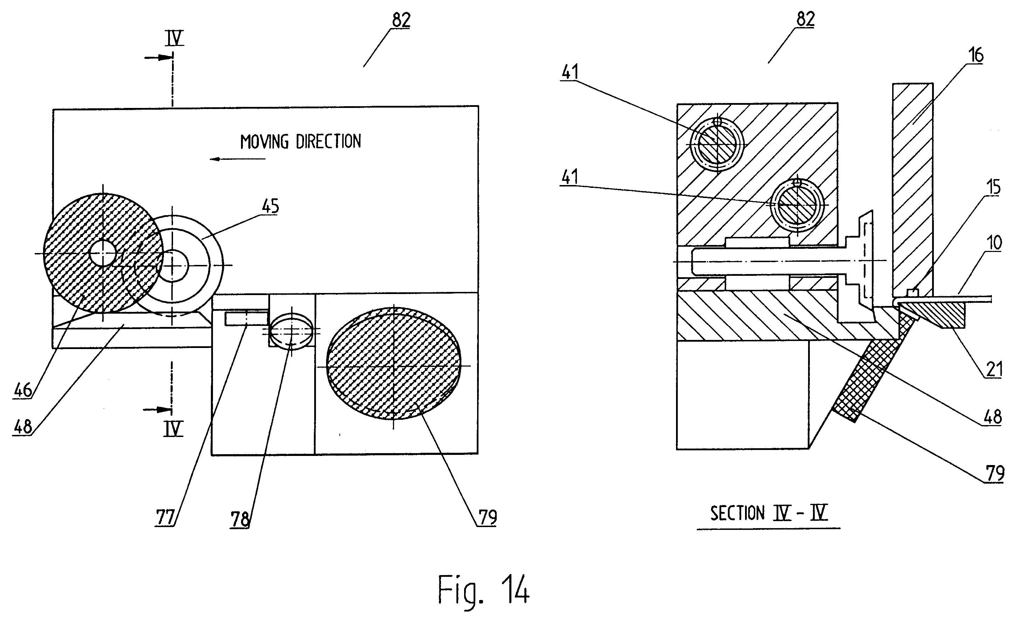

Fig. 14 shows a further trimming unit 80 which includes a combined bending and cutting head 82 and which may be used in the apparatus in accordance with the second embodiment of the present invention.

With reference to Fig. 14 a pressing roller 46, a cutting knife 45 which is preferably a rotating knife, a cutting edge 48, pre-bending rollers 77,78 and a final roller 79 are mounted on the cutting and bending head 82. By movement of the bending and cutting head 82 in the prescribed direction with the sequence of knife and rollers as shown, plate 10 is first cut and then bent in the way described individually for the first and second embodiments. A ultra-violet or infra-red heater 75 shown in Fig 12 may also be mounted on head 82 including, if required, the cooling jets 76. Alternatively, an extended heater 73 may attached to the base member 20 in a position to heat the end portion 14.

In accordance with this modification of the second embodiment of the invention, the pre-cut plate 10 or the leading edge of the roll 52 is located on the register pins 26. Handle 72 is moved to clamp pressing member 16 in place thus holding plate 10 adjacent to the bending edge 21. Vacuum may be applied to the channels 27. Then trimming unit 80 is moved across the width of the plate 10 to cut the plate 10 to the required length and to bend end portion 14 of the plate 10. Handle 72 is now released. The plate is removed as previously.

Finished plates 12 made in accordance with the second embodiment may be used in colour printing. A set of at least three polyester or paper backed printing plates 12 may be produced, each printing plate 12 representing a different colour content of a single image, each printing plate 12 having at least one bent edge or crimp and printing press reference locations or press alignment holes 3 and each printing plate 12 being mountable on a printing press so that each printing plate image 7 will be in alignment with each of said at least three printing plates 12 within a tolerance of less than ±30 micrometers.

With apparatus in accordance with any of the embodiments of the invention the sequence of operations can be automated. A control circuit may be provided (not shown) which controls the timing of appropriate valves and relays to apply vacuum, apply pressing member 16, move cutting, bending or combined cutting and bending units and to stop and start these units based on signals from position switches placed at appropriate positions on the base plate 20.

The present invention has been described above with reference to the first and second embodiments in which the punching units 30, the bending units 70 and the trimming units 40 are attached to the base member 20;60. The invention is not limited thereto. The unfinished plate 10 may be held on the base member 20;60 so that a substantial area of the plate 10 is in a predetermined position. The combined plate 10 and base member 20;60 may then be loaded into a numerically controlled machine (not shown) equipped with a laser cutter and a robot. Video cameras detect reference indicia on the plate 10 and the machine is controlled thereby to align the relative positions of the plate 10, the laser cutter and the robot. The laser cutter then cuts the press reference locations and trims the plate 10 to length according to a numerical program. A bending unit controlled by the robot is then applied to the cut edge 14 of the plate 10 and carries out the bending operation across the width of plate 10.

## Claims

1. **Apparatus** for processing an unfinished offset printing plate, said unfinished offset printing plate having at least one image therein and at least one registration indicia, each at least one image having a predetermined spatial relationship to the at least one registration indicia, comprising:

   a registration device for determining the position of the unfinished offset printing plate using the at least one registration indicia as a reference;

   means for holding the unfinished offset printing plate so that a substantial part of the unfinished printing plate is in a predetermined position with respect to said registration device;

   at least one reference location cutting device for cutting printing press reference locations in the unfinished offset printing plate in a predetermined spatial relationship to the at least one registration indicia; and

   a trimming unit for cutting the unfinished offset printing plate to a predetermined length with reference to the at least one registration indicia.

2. Apparatus according to claim 1, further comprising a base member.

3. Apparatus according to claim 2, wherein said base member includes a first part and a second part, said registration device being attached to said first part and said trimming unit being attached to said second part, and wherein said holding means is provided by means for tensioning the unfinished offset printing plate between said first and second parts and at least one pressing member for pressing the unfinished offset printing plate to said second part.

4. Apparatus according to claims 2 or 3, wherein said trimming unit includes a cutting knife and said base member includes a cutting edge projecting towards said cutting knife, said cutting edge co-operating with said cutting knife for cutting the unfinished offset printing plate.

5. Apparatus according to any of claims 1 to 4, further comprising a bending unit for bending an end portion of the unfinished offset printing plate.

6. Apparatus according to any of claims 1 to 4, wherein said trimming unit includes a bending unit for bending an end portion of the unfinished printing plate.

7. Apparatus according claims 5 or 6 as dependent upon any of claims 2 to 4, wherein said bending unit includes at least one bending roller, said base member includes a bending edge and said at least one bending roller and said bending edge co-operate to bend the end portion of the unfinished printing plate.

8. Apparatus according to any of claims 5 to 7 as dependent on any of claims 2 to 4, wherein said bending unit includes a pressing member for pressing the unfinished printing plate to said base member adjacent said bending edge.

9. Apparatus according to any of claims 5 to 8, wherein said bending unit includes a heating device for heating the end portion of the unfinished offset printing plate.

10. Apparatus according to any of claims 5 to 9, wherein said trimming unit includes a cutting knife and a cutting edge projecting towards said cutting knife, said cutting edge co-operating with said cutting knife for cutting of said unfinished offset printing plate.

11. Apparatus according to any of claims 2 to 10, wherein said holding means includes means for creating a vacuum immediately adjacent said surface of said base member.

12. **Method** for processing an unfinished flexible offset printing plate having at least one image therein and at least one registration indicia, whereby each at least one image is in a predetermined position with respect to said at least one registration indicia, comprising the steps of:

> positioning said unfinished offset printing plate using the at least one registration indicia as a reference;
>
> holding a substantial part of the unfinished offset printing plate in a predetermined position;
>
> cutting printing press reference locations into the unfinished offset printing plate using the at least one registration indicia as a reference; and
>
> trimming the unfinished offset printing plate to length using the at least one registration indicia as a reference without removing the printing plate from the apparatus, so that the image, the cut edge or edges and the printing press reference locations of the printing plate are in predetermined spatial relationships to each other and to the at least one registration indicia.

13. Method according to claim 12, wherein said trimming step includes bending an end portion of the unfinished offset printing plate.

14. Method according to claim 12, further comprising the step:

> bending an end portion of the unfinished offset printing plate.

15. Method according to claims 12 or 13, wherein the end portion is heated during bending.

**Amended claims in accordance with Rule 86(2) EPC.**

1. Apparatus (200) for processing an unfinished offset printing plate (10), said unfinished offset printing plate (10) having at least one image therein and at least one registration indicia (2), each at least one image having a predetermined spatial relationship to the at least one registration indicia (2), comprising:

> a registration device (26) for determining the position of the unfinished offset printing plate (10) using the at least one registration indicia (2) as a reference;
> means (27) for holding the unfinished offset printing plate (10) so that a substantial part of the unfinished printing plate (10) is in a predetermined position with respect to said registration device (26);
> at least one reference location cutting device (30) for cutting printing press reference locations (3) in the unfinished offset printing plate (10) in a predetermined spatial relationship to the at least one registration indicia (2);
> a trimming unit (40; 80) for cutting the unfinished offset printing plate (10) to a predetermined length with reference to the at least one registration indicia (2);
> a base member (20) including a bending edge (21), said registration device and said trimming unit being attached to said base member; and
> a bending unit (70; 80) for bending an end portion of the unfinished offset printing plate (10), characterized in that, said bending unit (70; 80) includes at least one bending roller (77-79), a bending edge (21) and said at least one bending roller (77-79) and said bending edge (21) co-operate to bend the end portion of the unfinished printing plate (10).

2. Apparatus according to claim 1, wherein said base member (20) includes a first part and a second part, said registration device (26) being attached to said first part and said trimming unit (40; 80) being attached to said second part and wherein said holding means (27) is provided by means (52) for tensioning the unfinished offset printing plate (10) between said first and second parts and at least one pressing member (10, 16) for pressing the unfinished offset printing plate (10) to said second part.

3. Apparatus (200) according to claim 1 or 2, wherein said trimming unit (40; 80) includes a cutting knife (45) and said base member (20) includes a cutting edge (22) projecting towards said cutting knife (25), said cutting edge (22) co-operating with said cutting knife (25) for cutting the unfinished offset printing plate (10).

4. Apparatus according to any of claims 1 to 3 wherein said trimming unit (40, 80) includes said bending unit (70, 80).

5. Apparatus according to any of claims 1 to 4, wherein said bending unit includes a heating device (73, 75) for heating the end portion of the unfinished offset printing plate (10).

6. Apparatus according to any of claims 1 to 5, wherein said trimming unit (40, 80) includes a cutting knife (45) and a cutting edge (48) projecting towards said cutting knife (45), said cutting edge (48) co-operating with said cutting knife (45) for cutting of said unfinished offset printing plate (10).

7. Apparatus according to any of claims 2 to 10, wherein said holding means (27) includes means (27) for creating a vacuum immediately adjacent said surface of said base member (20).

8. **Method** for processing an unfinished flexible offset printing plate having at least one image therein and at least one registration indicia, whereby each at least one image is in a predetermined position with respect to said at least one registration indicia, comprising the steps of:

    positioning said unfinished offset printing plate using the at least one registration indicia as a reference;
    holding a substantial part of the unfinished offset printing plate in a predetermined position;
    cutting printing press reference locations into the unfinished offset printing plate using the at least one registration indicia as a reference;
    trimming the unfinished offset printing plate to length using the at least one registration indicia as a reference without removing the unfinished printing plate from the apparatus, so that the image, the cut edge or edges and the printing press reference locations of the printing plate are in predetermined spatial relationships to each other and to the at least one registration indicia, and
bending an end portion of the unfinished offset printing plate using at least one bending roller.

9. Method according to claim 8, wherein said trimming step includes said bending step.

10. Method according to claims 8 or 9, wherein the end portion is heated during bending.

11. A set of at least three polyester or paper backed printing plates (12), each printing plate (12) representing a different color content of a single image, each printing plate (12) having at least one bent edge or crimp (14) and printing press reference locations or press alignment holes (3) and each printing plate (12) being mountable on the printing press so that each printing plate image will be in alignment with each of said at least three printing plates within a tolerance of less than $\pm 30$ micrometers.

FIG 1

3M    3M

FIG 2

3M    3M

FIG 3

SECTION III – III

Fig. 4

Fig. 5

EP 0 741 336 A1

40

I

MOVING DIRECTION

45

46

I

Fig. 6

42

40

43

42

41

41

45

44

SECTION I-I

POSITION OF CUTTING
EDGE 22

Fig. 7

EP 0 741 336 A1

FIG. 8

Fig. 9

EP 0 741 336 A1

Fig. 10

71
16
14
69
45
21

Fig. 11A

68
16
14
10
67
22
20

Fig. 11B

EP 0 741 336 A1

Fig. 12

MOVING DIRECTION

Fig. 13

EP 0 741 336 A1

SECTION Ⅳ - Ⅳ

MOVING DIRECTION

Fig. 14

23

| European Patent Office | EUROPEAN SEARCH REPORT | Application Number EP 95 10 6746 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-3 735 627 (EBURN, JR) * the whole document * --- | 1-15 | G03F9/00 |
| X | US-A-5 205 039 (TERNES) * column 4, line 31 - column 6, line 11 * --- | 1-5,12, 14 | |
| X | WO-A-90 02640 (MISOMEX U.K. LTD.) * claims 1,2 * ----- | 1,2,11, 12 | |
| | | | TECHNICAL FIELDS SEARCHED (Int.Cl.6) G03F |

The present search report has been drawn up for all claims

| Place of search THE HAGUE | Date of completion of the search 19 October 1995 | Examiner Balsters, E |
|---|---|---|